# EUROPEAN PATENT SPECIFICATION

(11) **EP 4 584 885 B1**
(45) Date of publication and mention of the grant of the patent: **04.11.2026**
(21) Application number: 22777676.2
(22) Date of filing: 05.09.2022
(51) Int. Cl.: H03K 3/38, H03K 19/195, H03K 19/00

(54) **METHODS AND ARRANGEMENTS FOR GENERATING SIGNALS WITH AQFP LOGIC**
VERFAHREN UND ANORDNUNGEN ZUR ERZEUGUNG VON SIGNALEN MIT AQFP-LOGIK
PROCÉDÉS ET AGENCEMENTS POUR GÉNÉRER DES SIGNAUX AVEC UNE LOGIQUE AQFP

(43) Date of publication of application: 16.07.2025
(73) Proprietor: IQM Quantum Computers Oyj, 02150 Espoo (FI)
(72) Inventor: SHARAFIEV, Aleksei, 81827 Munich (DE); YILMAZ, Ugur, 81737 Munich (DE); LÄHTEENMÄKI, Pasi, 02970 Espoo (FI)
(74) Representative: Papula Oy
(86) International application number: PCT/FI2022/050586
(87) International publication number: WO 2024/052585

(56) References cited:
- MASSOUD PEDRAM ET AL: "Design automation methodology and tools for superconductive electronics", COMPUTER-AIDED DESIGN, ACM, 2 PENN PLAZA, SUITE 701NEW YORKNY10121-0701USA, 5 November 2018 (2018-11-05), pages 1 - 6, XP058417781, ISBN: 978-1-4503-5950-4, DOI: 10.1145/3240765.3243470
- NAOKI TAKEUCHI ET AL: "Paper;An adiabatic quantum flux parametron as an ultra-low-power logic device;An adiabatic quantum flux parametron as an ultra-low-power logic device", SUPERCONDUCTOR SCIENCE AND TECHNOLOGY, IOP PUBLISHING, TECHNO HOUSE, BRISTOL, GB, vol. 26, no. 3, 28 January 2013 (2013-01-28), pages 35010, XP020241465, ISSN: 0953-2048, DOI: 10.1088/0953-2048/26/3/035010
- LUO WENHUI ET AL: "Low-Autocorrelation Random Number Generator Based on Adiabatic Quantum-Flux-Parametron Logic", IEEE TRANSACTIONS ON APPLIED SUPERCONDUCTIVITY, IEEE, USA, vol. 31, no. 5, 1 April 2021 (2021-04-01), pages 1 - 5, XP011852738, ISSN: 1051-8223, [retrieved on 20210430], DOI: 10.1109/TASC.2021.3070460

## Description

### FIELD OF THE INVENTION

The invention is generally related to the AQFP (Adiabatic Quantum-Flux-Parametron) technology. In particular the invention is related to the use of AQFP technology to generate signals that can be used e.g. to drive qubits in quantum computing.

### BACKGROUND OF THE INVENTION

The qubits of a quantum computing system must be kept at a very low temperature, such as only some millikelvins, during operation. This is typically achieved by placing the QPU (Quantum Processing Unit) containing the qubits at the mixing chamber stage of a cryostat in which a dilution refrigerator produces and maintains the lowest temperature. To drive the qubits, i.e. to provide them with the control signals necessary to perform quantum computing, the standard approach has been to generate the driving signals as GHz-frequency waveforms in the room temperature environment and to feed in them to the cryostat using thermally anchored cabling.

Attempts to scale up the size (in number of qubits) of a quantum computing system introduce problems related to the generation of heat. The dilution refrigerator has a relatively low cooling power at the lowest temperatures, for which reason the structure of the system should allow for as little heat conduction as possible from warmer parts to the lowest temperature stages. As every signal path represents also a potential heat conduction path, the number of signal paths to and from the lowest temperature stage should remain as small as possible. Cables of the kind needed are also very expensive, which is another motivating factor for not allowing their number per system to increase too much.

In addition to heat conducted from warmer parts, also heat generated locally at the coldest stage loads the cooling arrangement. The circuitry used to drive the qubits should be such that it generates as little heat as possible through power dissipation.

Yet another factor to consider is the power consumption of the electronics located outside the cryostat, in the room temperature environment.

All these factors have driven the development of quantum computing systems towards building digitally controllable superconducting drivers and associated logic inside the cryogenic environment, next to the QPU. A suggested approach to building these kinds of circuits involves Adiabatic Quantum-Flux-Parametron (AQFP) technology, in which very accurately controlled AC excitation currents serve as both clock signals and power supplies to signal generators that rely upon driving a Josephson junction (or an array of Josephson junctions) close to its critical current. This gives rise to sequences of small, rapid control voltage pulses that - when coupled appropriately to the qubit - subject the qubit to respective incremental rotations on the Bloch sphere. Almost arbitrary rotations can be produced by applying a corresponding sequence of pulses, which is synonymous to controllably driving the qubit.

In addition to quantum computing, AQFP technology can be used to implement power-efficient high performance classical computing where the ultimate goal is to approach the Landauer limit and reversible computing. According to the Landauer principle, any logically irreversible manipulation of information must be accompanied by a corresponding entropy increase in non-information-bearing degrees of freedom of the information-processing apparatus or its environment. A consequence thereof is the so-called Landauer limit of the number of computations that may be performed per joule of energy. Reversible computing means an isentropic computing process, i.e. computational operations that result in no increase (theoretically) or very little increase (practically) in physical entropy.

Problems of known AQFP technology are related to finding an optimal balance between factors like the plasma frequency, critical current, and subgap dissipation of the Josephson junction(s); the value of and consequent shunt dissipation in the terminating resistive impedance of the transmission line used to convey the generated voltage pulses; and the clock frequency used in generating the control voltage pulses. Prior art related to this technical field is known for example from the document MASSOUD PEDRAM ET AL: "Design automation methodology and tools for superconductive electronics", COMPUTER-AIDED DESIGN, ACM, 2 PENN PLAZA, SUITE 701 NEW YORKNY10121-0701 USA, 5 November 2018 (2018-11-05), pages 1-6, XP058417781, DOI: 10.1145/3240765.3243470 ISBN: 978-1-4503-5950-4.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

It is an objective to provide a method and an arrangement for generating driving signals for qubits in a way that enables scaling up the size of the quantum computing system while avoiding the known problems that relate to heat load.

These and further advantageous objectives are achieved by synchronising the common clock signal of the AQFP circuitry with the oscillations at the plasma frequency of the Josephson junction(s).

According to a first aspect, there is provided an Adiabatic Quantum-Flux-Parametron circuit, which may also be called an AQFP circuit. The AQFP circuit comprises a Josephson junction or an array of Josephson junctions, said Josephson junction or each Josephson junction in said array having a respective plasma frequency, and a clocking signal line. The AQFP circuit comprises an inductive coupler between said clocking signal line and said Josephson junction, or an array of inductive couplers between said clocking signal line and each Josephson junction in said array, respectively. The AQFP circuit comprises a data signal line between a data signal source and said Josephson junction or each Josephson junction in said array. The AQFP circuit is configured to feed into said clocking signal line an oscillating clocking signal having a clocking signal frequency, said clocking signal frequency being selected so that said plasma frequency or each respective plasma frequency is an integral multiple of said clocking signal frequency.

According to an embodiment, the AQFP circuit is configured to feed into said clocking signal line, as said oscillating clocking signal, a compressed sinusoidal waveform that contains a base frequency and a predetermined set of harmonics of said base frequency. This involves at least the advantage that transitions in the oscillating clocking signal become steeper and the peaks flatter in comparison to a purely sinusoidal signal, creating a kind of injection locking effect.

According to an embodiment the AQFP circuit is configured to feed into said clocking signal line, as said oscillating clocking signal, an oscillating signal a base frequency of which is higher than 5 GHz, preferably higher than 10 GHz, and most preferably higher than 12 GHz. This involves at least the advantage of allowing significantly faster operations than previously known AQFP circuits.

According to an embodiment, the AQFP circuit is configured to feed into said data signal line a data pattern of varying polarities, for making an output current of said AQFP circuit exhibit a pulsed form in which consecutive current pulses have polarities following said varying polarities of the data pattern. This involves at least the advantage that the output allows driving a large variety of desired changes in the state of a qubit.

According to an embodiment, said clocking signal line, said Josephson junction (or array of Josephson junctions), said inductive coupler (or array of inductive couplers), and said data signal line belong to a sequence generator that has an output, said data signal line being an input of said sequence generator. The AQFP circuit may then comprise a control pulse generator coupled to said output of said sequence generator, configured to use the pulsed form of the output current of said sequence generator to produce a corresponding sequence of control voltage pulses. This involves at least the advantage that also real-valued impedances can be driven with said voltage pulses.

According to an embodiment, said control pulse generator comprises a further Josephson junction or a further array of Josephson junctions, a further clocking signal line, a further inductive coupler between said further clocking signal line and said further Josephson junction (or a further array of inductive couplers between said further clocking signal line and each Josephson junction in said further array, respectively), and a further data signal line between said output of said sequence generator and said further Josephson junction (or each Josephson junction in said further array) . The AQFP circuit may then be configured to feed into said further clocking signal line a further oscillating clocking signal, a base frequency of which is lower than the base frequency of the oscillating clocking signal fed into the clocking signal line of the sequence generator. This involves at least the advantage of enabling the generation of driving pulses for qubits in a particularly advantageous way.

According to a second aspect, there is provided a method for operating an Adiabatic Quantum-Flux-Parametron circuit, in the following an AQFP circuit. The AQFP circuit meant here comprises a Josephson junction or an array of Josephson junctions, said Josephson junction or each Josephson junction in said array having a respective plasma frequency; a clocking signal line; an inductive coupler between said clocking signal line and said Josephson junction (or an array of inductive couplers between said clocking signal line and each Josephson junction in said array, respectively; and a data signal line between a data signal source and said Josephson junction (or each Josephson junction in said array). The method comprises feeding into said clocking signal line an oscillating clocking signal having a clocking signal frequency and selecting said clocking signal frequency so that said plasma frequency or each respective plasma frequency is an integral multiple of said clocking signal frequency.

According to an embodiment the method comprises feeding into said clocking signal line, as said oscillating clocking signal, a compressed sinusoidal waveform that contains a base frequency and a predetermined set of harmonics of said base frequency. This involves at least the advantage that transitions in the oscillating clocking signal become steeper and the peaks flatter in comparison to a purely sinusoidal signal, creating a kind of injection locking effect.

According to an embodiment, the method comprises feeding into said clocking signal line, as said oscillating clocking signal, an oscillating signal a base frequency of which is higher than 5 GHz, preferably higher than 10 GHz, and most preferably higher than 12 GHz. This involves at least the advantage of allowing significantly faster operations than previously known AQFP circuits.

According to an embodiment, the method comprises feeding into said data signal line a data pattern of varying polarities, for making an output current of said AQFP circuit exhibit a pulsed form in which consecutive current pulses have polarities following said varying polarities of the data pattern. This involves at least the advantage that the output allows driving a large variety of desired changes in the state of a qubit.

According to a third aspect, there is provided a quantum computing system comprising at least one AQFP circuit of a kind described above.

According to a fourth aspect, there is provided a quantum computing method comprising, as a part of the method, operating an AQFP circuit in accordance with any of the methods described above.

### BRIEF DESCRIPTION OF THE DRAWINGS

The accompanying drawings, which are included to provide a further understanding of the invention and constitute a part of this specification, illustrate embodiments of the invention and together with the description help to explain the principles of the invention. In the drawings:
**figure 1** illustrates a quantum computing system,
**figure 2** illustrates a principle of using a stream of adiabatically generated voltage pulses to drive a qubit,
**figure 3** illustrates an example embodiment of a circuit that can be used to realize the principle of fig. 2,
**figure 4** illustrates examples of signals used to generate voltage pulses,
**figure 5** illustrates an AQFP circuit according to an embodiment,
**figure 6** illustrates currents in certain parts of the AQFP circuit of fig. 5,
**figure 7** illustrates current waveforms in a circuit like that of fig. 5,
**figure 8** illustrates a base frequency and a set of harmonics in an oscillating clocking signal,
**figure 9** illustrates an output signal of an AQFP circuit that went unstable,
**figure 10** illustrates an output signal of an AQEP circuit,
**figure 11** illustrates an output signal of an AQEP circuit,
**figure 12** illustrates an output signal of an AQEP circuit
**figure 13** illustrates a part of a quantum computing system,
**figure 14** illustrates a possible implementation of the principle of fig. 13 in more detail,
**figure 15** illustrates current and voltage waveforms in a quantum computing system like that of fig. 14,
**figure 16** illustrates an AQFP circuit according to an embodiment, and
**figure 17** illustrates an abstraction of the circuit of fig. 16.

### DETAILED DESCRIPTION

In the following description, reference is made to the accompanying drawings, which form part of the disclosure, and in which are shown, by way of illustration, specific aspects in which the present disclosure may be placed. It is understood that other aspects may be utilised, and structural or logical changes may be made without departing from the scope of the present disclosure. The following detailed description, therefore, is not to be taken in a limiting sense, as the scope of the present disclosure is defined by the appended claims.

For instance, it is understood that a disclosure in connection with a described method may also hold true for a corresponding device or system configured to perform the method and vice versa. For example, if a specific method step is described, a corresponding device may include a unit to perform the described method step, even if such unit is not explicitly described or illustrated in the figures. On the other hand, for example, if a specific apparatus is described based on functional units, a corresponding method may include a step performing the described functionality, even if such step is not explicitly described or illustrated in the figures. Further, it is understood that the features of the various example aspects described herein may be combined with each other, unless specifically noted otherwise.

In the following, reference is first made to some suggested ways of using AQFP technology in a quantum computing system. It is to be noted, however, that the invention is not limited to applications with quantum computing but can also be utilised in power-efficient high performance classical computing.

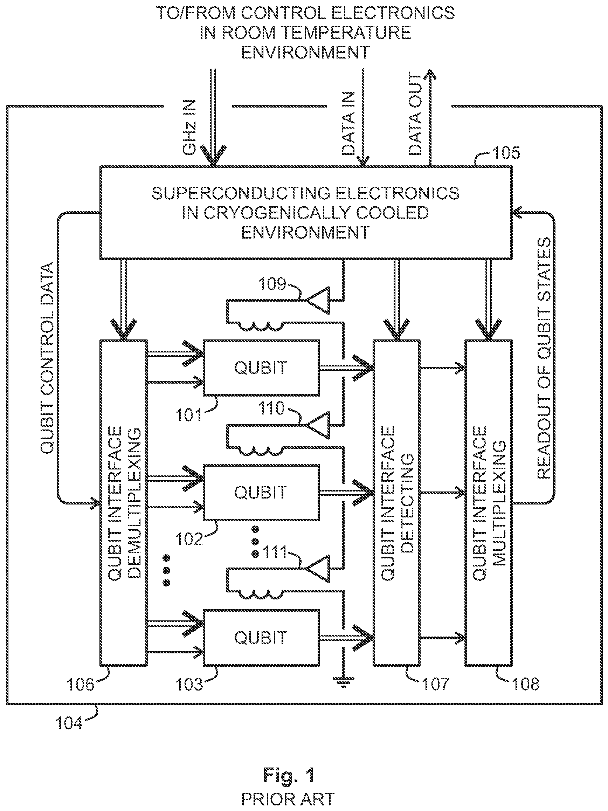

Fig. 1 illustrates schematically a quantum computing system that comprises N qubits, where N is a positive integer. Of said N qubits, three qubits 101, 102, and 103 are shown in fig. 1. The outer perimeter 104 represents a cryogenically cooled environment for maintaining the qubits at the required very low temperature. In the embodiment shown in fig. 1, the gigahertz-range frequencies needed to make the qubits perform quantum computing operations are brought in from control electronics located in the surrounding room temperature environment. It is also possible to controllably generate gigahertz-range frequencies within the cryogenically cooled environment, using for example the technology explained in a co-pending European patent application EP20712003.1, published as EP3939160.

Data that conveys the input information to be used in the quantum computing operations is brought in from the room temperature environment. Similarly, data that conveys the output results of the quantum computing operations are brought out to the room temperature environment. Both data streams are shown schematically in fig. 1.

In addition to the qubits, the system comprises superconducting electronics in the cryogenically cooled environment. A bulk of such superconducting electronics is shown as block 105 in fig. 1. Input couplings from said block to the qubits 101, 102, and 103 are shown as going through a qubit interface demultiplexing block 106 in fig. 1. On the output side of the qubits, there are a qubit interface detecting block 107 for detecting the quantum states acquired by the qubits, as well as a qubit interface multiplexing block 108 for conveying the detection data further to the main superconducting electronics block 105. Additionally, fig. 1 shows schematically some bias circuits 109, 110, and 111 for calibrating the qubits 101, 102, and 103 respectively.

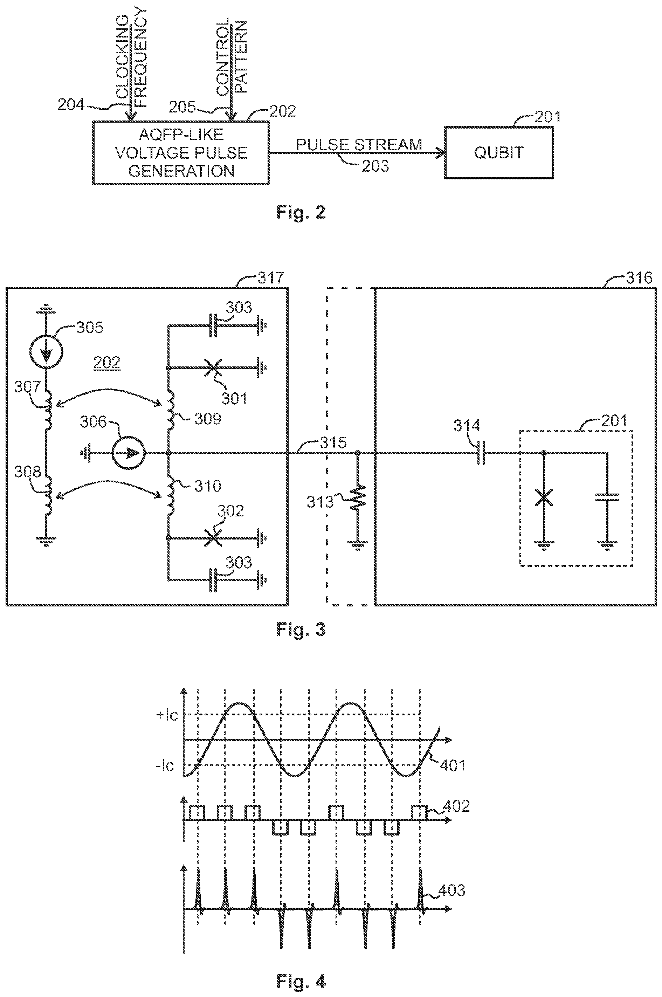

Fig. 2 illustrates a part of a quantum computing system. The shown part comprises a qubit 201 and a driving circuit 202. The purpose of the driving circuit 202 is to provide a stream 203 of driving pulses to the qubit 201. In this respect, the general approach to driving the qubit 201 has some resemblance to the known SFQ (Single Flux Quantum) principle: each driving pulse in the stream 203 may subject the qubit 201 to an incremental rotation on the Bloch sphere, so that (almost) arbitrary rotations can be produced by applying a corresponding sequence of pulses. The generation of said pulses in the driving circuit utilizes two input signals, which are called the clocking frequency 204 and the control pattern 205 in fig. 2.

Fig. 3 shows one illustrative example of how the principle of fig. 2 could be implemented in practice. In this case, the driving circuit 202 is configured to produce the driving pulses by repetitively causing currents through one or more Josephson junctions in the driving circuit 202 and through associated additional current paths to vary in a particular way that is closely associated with the Josephson dynamics governing the behaviour of the junctions.

The driving circuit 202 of fig. 3 comprises two Josephson junctions 301 and 302. A respective capacitance 303 or 304 is shown as coupled parallel to each Josephson junction 301 or 302, but these are merely representatives of the inherent capacitances that cannot be avoided and that must be taken into account in accurately analysing the behaviour of the circuit in fig. 3.

A first current source 305 and a second current source 306 are shown as parts of the driving circuit 202. The actual current sourcing parts of the first and second current sources 305 and 306 are not necessarily part of the driving circuit 202 proper; the current sources can be located somewhere more distant so that only the currents they generate are brought in through suitable couplings to the driving circuit 202. Comparing to fig. 2, the first current source 305 is configured to produce the clocking frequency 204 and the second current source 306 is configured to produce the control pattern 205.

A first inductive current path couples the first current source 305 to a reference potential which is here shown to be the ground potential. Along said first inductive current path are separately shown two inductances 307 and 308. Whether they are parts of the same inductive component or implemented as separate inductive components, and whether there are more inductances than those two along the first inductive current path is irrelevant for the following description.

The Josephson junctions 301 and 302 are coupled between the second current source 306 and a reference potential through respective second inductive current paths. In the example implementation of fig. 3, an inductance 309 exists between the second current source 306 and the first Josephson junction 301 and another inductance 310 exists between the second current source 306 and the second Josephson junction 302.

The first inductive current path is inductively coupled to the respective second inductive current paths. This inductive coupling is schematically shown in fig. 3 as a coupling between inductances 307 and 309 as well as a coupling between inductances 308 and 310. Due to these inductive couplings, a current that flows through the first inductive current path induces a corresponding current through the respective second inductive current paths. In other words, by making the first current source 305 generate an AC electric current of desired frequency and amplitude, one may "pump" energy across the inductive couplings into the second inductive current paths, where the pumped energy affects the currents through the respective Josephson junctions 301 and 302.

Each Josephson junction has a critical current, i.e. a parameter value that defines the upper limit of the magnitude of electric current that can flow through the junction. If a Josephson junction is subjected to an externally applied alternating current the peak amplitude of which is larger than the critical current, and if a suitable additional current path is also available that forms a loop with the Josephson junction, during each cycle (i.e. 2*pi phase rotation) of the alternating current certain interesting variations may be observed in the currents through the various paths in synchronism with the peaks of the positive and negative half-wave of the AC current form. The absolute magnitude of the alternating current will be briefly equal to the critical current four times during each 2*pi phase rotation: on both sides of the peak of the positive half-wave and on both sides of the peak of the negative half-wave.

Fig. 4 shows three graphs. The top graph 401 shows the magnitude of an alternating current of the kind described above: its absolute magnitude exceeds the critical current value Ic at the peaks of the positive and negative half-wave of the AC current form. In the following, we assume that the first current source 305, the first inductive current path 307-308, the second inductive current paths 309 and 310, and the inductive couplings between the current paths are used in an attempt to drive a current of this kind to each of the Josephson junctions 301 and 302.

Simultaneously, the second current source 306 is used to produce a pulsating current of the kind shown by the second graph 402 in fig. 4. Said pulsating current consists of bipolar current pulses, i.e. brief pulses of either positive or negative current according to a predetermined pattern. In this example the output current of the second current source 306 returns to zero between each consecutive pulse.

It turns out that as a result, rapid voltage pulses occur across a terminating resistive impedance 313 of the transmission line 315 that couples the common point of the second current source 306 and the inductances 309 and 310 to the coupling capacitance 314 of the qubit 201. The third graph 403 in fig. 4 illustrates said voltage pulses. Each of said voltage pulses occurs at the moment when the induced current illustrated by the first graph 401 crosses the +Ic or -Ic value in the positive or negative direction (see the vertical dashed lines in fig. 4). The polarity of each of said voltage pulses follows the polarity of the corresponding current pulse in the output of the second current source 306, as shown by the second graph 402.

As there are two complementary pulse polarities, these can be designated as bit values in order to easily refer to pulse sequences in terms of bit patterns. For example, assuming a polarity convention in which a positive voltage pulse represents a "1" and a negative voltage pulse represents a "0", the pulse sequence represented by the lowest graph 403 in fig. 4 would be "111001001".

Intuitively, the generation of the bipolar voltage pulses illustrated by the third graph 403 may be explained as follows. Each of the Josephson junctions 301 and 302 can only conduct an electric current smaller than or equal to the critical current Ic. Also, each junction can only store a finite amount of energy. Due to circuit dynamics, crossing the threshold corresponding to that energy results in the stored energy being "dumped" somewhere. This may correspond for example to a change in the state of the system, like in the case of a standard AQFP buffer cell in which a current (of one polarity or the other) will begin to flow in the output inductor when a clock current threshold is crossed. In the circuit of fig. 3, the result can be seen as an output voltage pulse. In order to minimize reflections, the terminating resistive impedance 313 may be a 50 ohms impedance.

In general, and comparing to fig. 2, the driving circuit 202 can be said to provide a stream of driving pulses to the qubit 201. More particularly, the driving circuit 202 is configured to produce said driving pulses as bipolar voltage pulses 403 so that a driving voltage in each driving pulse deviates from zero to either positive or negative direction and the stream 203 of driving pulses contains pulses of both polarities in a predetermined sequence.

By dimensioning the components and couplings suitably, the driving circuit 202 may be configured to produce said driving pulses so that the time integral of each driving pulse voltage equals the superconducting flux quantum h/2e, where h is the Planck constant and e is the elementary charge.

In order to estimate the total dissipation, one may assume that the qubit resonance frequency is about 5 GHz and that so-called fidelity optimized driving sequences (known from Kangbo Li, R.McDermott, Maxim G. Vavilov: "Scalable Hardware-Efficient Qubit Control with Single Flux Quantum Pulse Sequences", arXiv:1902.02911v1, 8 Feb 2019) are used. The last-mentioned means a requirement of the bit rate represented by the voltage pulses 403 to be about five times the qubit frequency, i.e. about 25 Gbps, so the total dissipation may be around 250 pW per qubit. This is far below any conceivable alternative that could be accomplished by traditional resistively shunted SFQ drivers.

Taking the assumption of about 25 Gbps bit rate represented by the voltage pulses 403 and noting that four voltage pulses will occur per cycle in the clocking frequency 204, the magnitude of the clocking frequency should be around 6.25 GHz. If the control pattern 205, i.e. the pulsed output current of the second current source 306, is produced using an oscillating triggering signal where each peak (positive or negative) triggers one current pulse, two current pulses will be generated per each cycle in the triggering signal. Again, assuming the 25 Gbps bit rate, the frequency of the triggering signal should thus be one half of that or about 12.5 GHz.

As the polarity of the corresponding voltage pulse (graph 403 in fig. 4) will be determined by the polarity of the corresponding current pulse (graph 402 in fig. 4), it is advantageous to generate the current pulses so that each current pulse has assumed a stable polarity at the moment when the induced current (graph 401 in fig. 4) equals the critical current +Ic or -Ic. In fig. 4, this is seen in that the vertical dashed lines occur essentially in the middle of each current pulse in graph 402. Generating the rising and falling edges in a triggering signal like that of graph 402 will inevitably involve some jitter, for which purpose it is not advisable to time the generation of any voltage pulse very close to any rising or falling edge of the current pulses.

Taken the relatively high frequencies mentioned above (25 Gbps bit rate, 12.5 GHz frequency of the triggering signal), the inherent characteristics of AQFP logic concerning speed and power dissipation come into question. These are basically limited by the plasma frequencies of the Josephson junctions, but also the critical current has a role. The plasma frequency of a Josephson junction is indicative of the appearance of the junction as a nonlinear LC resonator. A high plasma frequency would be desirable, because it enhances stability and allows using larger shunt values, which in turn decreases dissipation in the shunt. Increasing plasma frequency also increases subgap dissipation. Decreasing critical current would also decrease dissipation, but both attempts of increasing plasma frequency and attempts to decrease critical current tend to require such smaller and smaller junction areas that known fabrication standards begin to meet their limits. Additionally, decreasing the critical current easily increases noise sensitivity up to impractical values, and attempts to increase the clock frequency by lowering the shunt value increases dissipation in the shunt.

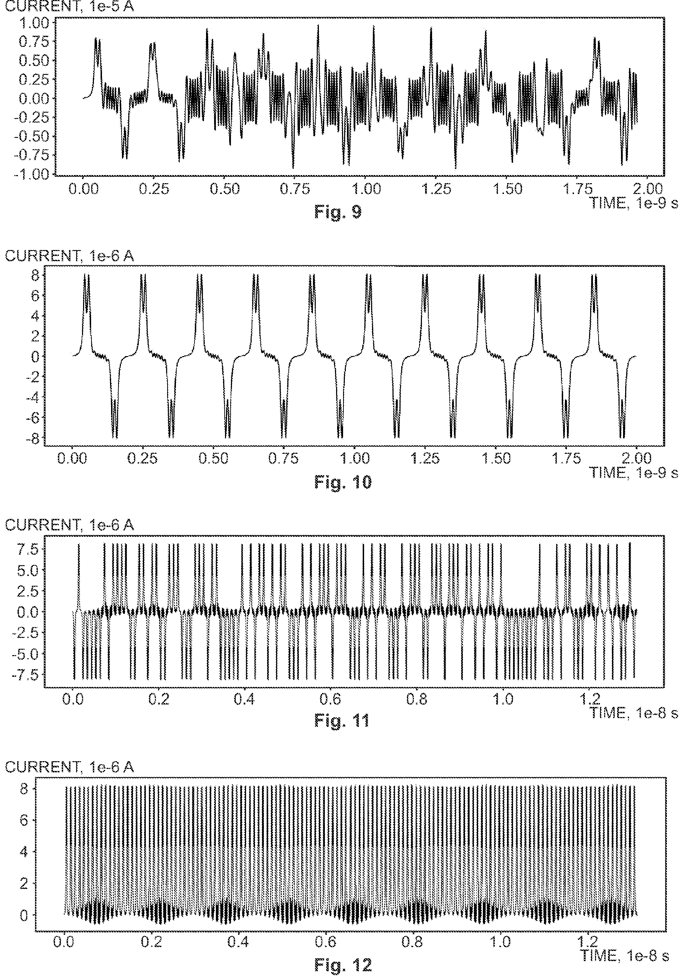

The references above to the stability of an AQFP circuit mean that the output of the circuit does not exhibit uncontrolled oscillations but only the intended pulses of output current (or output voltage across a shunt of the output transmission line). Fig. 9 illustrates a simulated output current of an AQFP circuit that goes unstable. In known solutions, the circuit would be stabilized by allowing enough time for the state-transition-introduced plasma oscillations to die after each such transition or by reducing the amount of energy deposited during such transitions. In the case of fig. 9, the repeated injections of additional energy by the clocking signal cause energy to be accumulated in the plasma oscillations up to a level at which the excess energy destroys the stability of the circuit.

As a novel finding, it has now been found that it is possible to avoid the accumulation of excess energy in the plasma oscillations by timing the clocking signal appropriately. In particular, the clocking signal frequency should be selected so that the plasma frequency, which is an inherent feature of the Josephson junctions and their microwave environment, is an integral multiple of the clocking signal frequency. Or, in other words, the AQFP circuit should be engineered so that the plasma frequency (or each plasma frequency, if the Josephson junctions in an array have different plasma frequencies) fulfils said criterion with respect to the clocking frequency.

The consequence of such a relation between the plasma frequency and the clocking signal frequency is that any energy initially deposited into plasma oscillation during a transition from zero current to a positive or negative current-conducting state is removed upon the subsequent return to zero current. This prevents energy from accumulating in the plasma oscillations and consequently preserves the stability of the AQFP circuit.

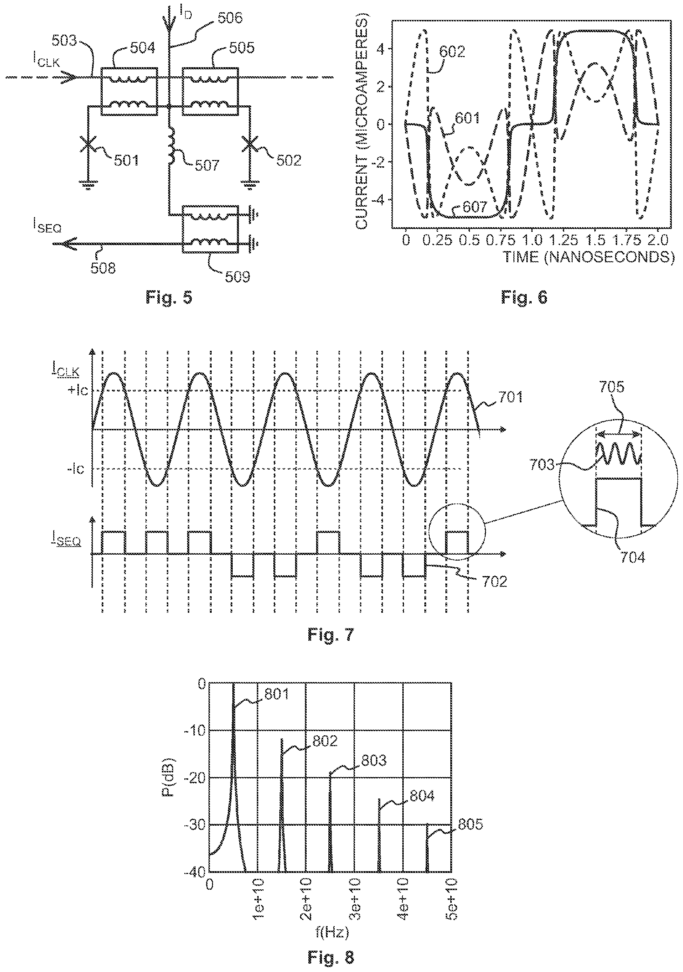

This phenomenon is explained next with reference to fig. 5 and others. The AQFP circuit in fig. 5 comprises an array of two Josephson junctions 501 and 502. Each of these has a respective plasma frequency. For simplicity, it may be assumed here that the two Josephson junctions 501 and 502 are identical enough so that they have essentially the same plasma frequency.

A clocking signal line 503 goes through the AQFP circuit, in the horizontal direction in this graphical representation. The AQFP circuit shown in fig. 5 may be a part of a larger circuit, in which the same clocking signal line 503 may go similarly through a number of "cells" or "buffers", as the entity in fig. 5 can be called.

The AQFP circuit of fig. 5 comprises a first inductive coupler 504 between the clocking signal line 503 and the first Josephson junction 501 and a second inductive coupler 505 between the clocking signal line 503 and the second Josephson junction 502. In general, it may be said that the AQFP circuit comprises an inductive coupler between the clocking signal line and the Josephson junction, or an array of inductive couplers between said clocking signal line and each Josephson junction in an array respectively.

Additionally, the AQFP circuit of fig. 5 comprises a data signal line 506 between a data signal source (not shown in fig. 5) and both Josephson junctions 501 and 502. Also here, in order to preserve generality, it can be said that the AQFP circuit comprises a data signal line between a data signal source and the Josephson junction or each Josephson junction in an array.

The AQFP circuit is configured to feed into the clocking signal line 503 an oscillating clocking signal that has a clocking signal frequency. In accordance with the novel principle outlined above, said clocking signal frequency has been selected so that the plasma frequency or each respective plasma frequency in the array of Josephson junctions 501 and 502 is an integral multiple of said clocking signal frequency.

Fig. 6 illustrates simulated current waveforms in the first Josephson junction 501 (graph 601), the second Josephson junction 502 (graph 602), and the inductor 507 (graph 607). The inductor 507 is, on one hand, part of a loop with the first Josephson junction 501. On the other hand, the inductor 507 is also part of a loop with the second Josephson junction 502. When the current induced by the clocking signal on the clocking signal line 503 reaches a transition point where the critical current of either Josephson junction would be exceeded, currents in one of said loops (depending on the polarity of the data signal on the data signal line 506) assume a state in which the current 607 through the inductor 507 suddenly increases and the current through the respective Josephson junction simultaneously flips so that exceeding the critical current is avoided. These events occur at 0.2, 0.8, 1.2, and 1.8 nanoseconds in the time scale used in fig. 6.

Fig. 7 illustrates an oscillating clocking signal I_{CLK} with the upper graph 701. The horizontal lines at +Ic and -Ic show the current levels at which the corresponding current induced through the inductive couplers 504 and 505 reaches the critical current of the Josephson junctions 501 and 502. In comparison to the circuit of fig. 3 above, it may be noted that there is no output transmission line terminated with a resistive impedance in fig. 5. Instead, there is a coupling through the inductance 507 to a further inductive coupler 509, which generates an output current of the AQFP circuit shown in fig. 5 on the output line 508.

As a result of said difference, there are no output voltage peaks coincident with the graph 701 crossing the horizontal lines at +Ic and -Ic as there were in fig. 4. Instead, the output current I_{SEQ} of the AQFP circuit has a pulsating form, as shown by the lower graph 702 in fig. 7. Each pulse in the output current I_{SEQ} coincides with, and has the same duration as, the period during which the absolute value of the oscillating clocking signal 701 remains larger than the critical current Ic. Whether a positive or negative current pulse is produced, depends on the simultaneous value of the data signal I_{D} that is fed into the data signal line 506 shown in fig. 5.

A result of the plasma frequency being an integral multiple of the clocking signal frequency is seen in the partial enlargement on the right in fig. 7. The smaller oscillating graph 703 represents the plasma oscillations in the Josephson junction(s). The rising and falling edges of the current pulse 704 occur in phase with the plasma oscillations. In this simplified graphical example, exactly three complete wavelengths of the plasma oscillations 703 fit in the period of time 705 that represents the duration between the rising and falling edges of the current pulse 704. As the plasma frequency is an integral multiple of the clocking signal frequency, the same holds true during each pulse in the output current 702.

Fig. 10 shows the result of a simulation in which a regular pattern 10101010... was used as the data signal fed into the data signal line 506. Correspondingly, figs. 11 and 12 show the results of similar simulations in which an irregular pattern of 1's and 0's was used (fig. 11) or the pattern consisted solely of 1's (fig. 12). The simulations were produced using the jsim software, which models the actual physical characteristics of the AQFP circuit quite accurately and consequently gives very reliable indications of how the output current would look like also in a real-life AQFP circuit of this kind.

During the research that led to the findings described here it was additionally found that most advantageously the oscillating clocking signal fed into the clocking signal line 503 is a so-called compressed sinusoidal waveform. In other words, as shown in the illustrative example in fig. 8, it contains a base frequency 801 and a predetermined set of harmonics 802, 803, 804, and 805 of said base frequency 801. Such compressed sinusoidal waveforms may be generated for example by power compression in the clock feed. The addition of harmonics tends to make the transitions steeper and the peaks flatter in comparison to a purely sinusoidal signal. The advantageous characteristics of compressed sinusoidal waveforms as clocking signals are believed to be related to a kind of injection locking effect.

Not having to slow down the clocking signal for ensuring stability of the AQFP circuit allows using much higher clocking signal frequencies than in previously known AQFP circuits. As an example, the AQFP circuit may be configured to feed into the clocking signal line 503, as the oscillating clocking signal 701, an oscillating signal a base frequency of which is higher than 5 GHz, or higher than 10 GHz, or even higher than 12 GHz.

As already suggested above, the AQFP circuit may be configured to feed into the data signal line 506 a data pattern of varying polarities. This will make the output current of the AQFP circuit exhibit a pulsed form in which consecutive current pulses have polarities following said varying polarities of the data pattern.

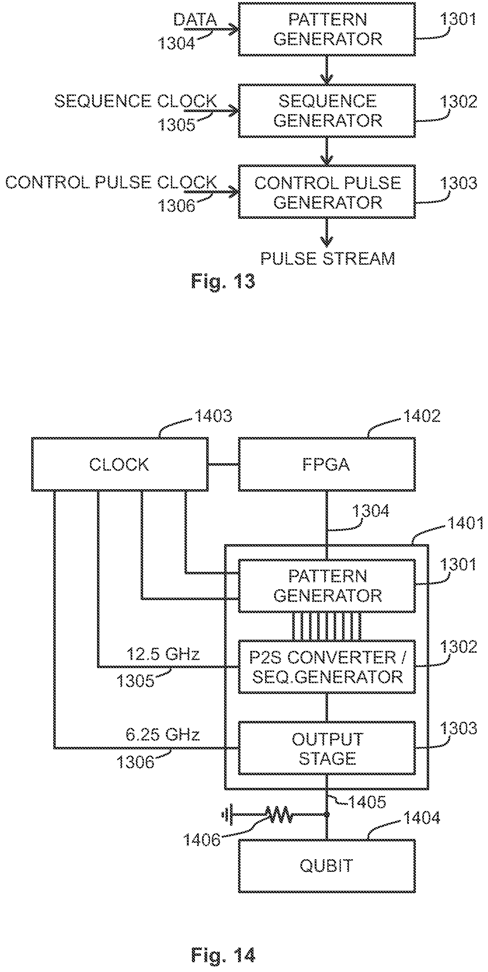

The rectangular current pulses typical to AQFP logic, with two state transitions each, cannot efficiently drive power into a real-valued impedance. The last-mentioned is, however, a prerequisite for driving qubits in accordance with the SFQ principle. On the other hand, an AQFP circuit of the kind described above can be operated (and yet kept stable) at a much higher frequency than previously known AQFP circuits. Consequently, an arrangement may be built having the general structure shown in fig. 13.

The arrangement comprises a pattern generator 1301, the task of which is to generate the bit patterns that eventually govern the driving of the qubit. In other words, said bit patterns will define the polarities of the control voltage pulses that will drive the state of the qubit through the desired incremental rotations on the Bloch sphere.

The patterns generated by the pattern generator 1301 act as inputs to a sequence generator 1302, which may have the general structure shown earlier in fig. 5. Comparing to fig. 5, the clocking signal line 503, the array of Josephson junctions 501 and 502, the array of inductive couplers 504 and 505, and the data signal line 506 belong to the sequence generator 1302. The data signal line 506 is an input of the sequence generator 1302, and the output line 508 is an output of the sequence generator 1302.

The arrangement of fig. 13 comprises a control pulse generator 1303 coupled to the output of the sequence generator 1302. The control pulse generator 1303 is configured to use the pulsed form of the output current of the sequence generator 1302 to produce a corresponding sequence of control voltage pulses. The control pulse generator 1303 may be of the kind shown in fig. 3, for example. Its output comprises the stream of control voltage pulses to the qubit.

The data input 1304 of the pattern generator 1301 and the clocking signal inputs 1305 and 1306 of the sequence generator 1302 and control pulse generator 1303 are shown on the left in fig. 13.

Fig. 14 shows a possible more detailed implementation of the principle shown in fig. 13. The implementation in fig. 14 comprises an AQFP circuit 1401, an FPGA (Field Programmable Gate Array) circuit 1402, and a clock circuit 1403. Within the AQFP circuit 1401 are a pattern generator 1301, a sequence generator 1302 and a control pulse generator 1303, of which the last-mentioned is more generally designated as an output stage in fig. 14. The FPGA circuit 1402 provides the pattern generator 1301 with input data through the data input 1304. The clock circuit 1403 provides all other circuits with their required clocking signals.

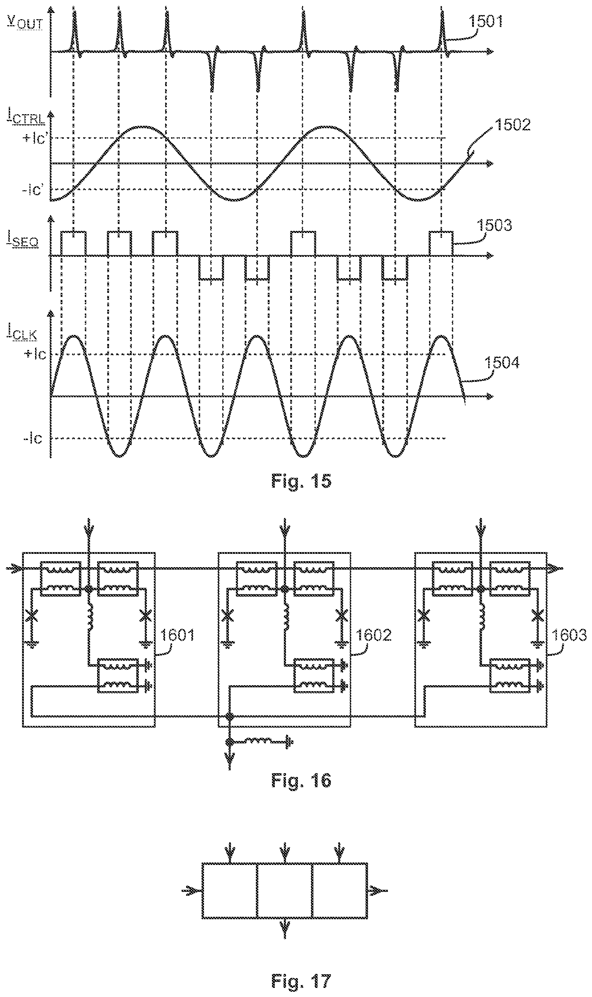

As shown earlier in figs. 4 and 7, the pulsed output current from the sequence generator 1302 has two pulses per each period of the clocking signal coming in on line 1305, whereas the output stage or control pulse generator 1303 generates four control voltage pulses per each period of the respective clocking signal coming in on line 1306. Thus, aiming at a control voltage pulse rate of 25 GHz, the frequency of the clocking signal coming in on line 1305 should be 12.5 GHz while the frequency of the clocking signal coming in on line 1306 may be one half of that, i.e. 6.25 GHz. These frequency relations are shown also in fig. 15, in which the topmost graph 1501 illustrates the control voltage pulses, the second graph 1502 illustrates the clocking signal on line 1306, the third graph 1503 illustrates the pulsed output current from the sequence generator 1302, and the lowest graph 1504 illustrates the clocking signal on line 1305.

The sequence generator 1302 is shown to also comprise a parallel to serial converter in fig. 14. This property of the sequence generator 1302 eases the operating rate requirement of the pattern generator 1301, because it only needs to operate at a rate that is the clocking frequency of the sequence generator 1302 divided by the number of parallel data lines between blocks 1301 and 1302. More conventional techniques can be utilised to optimise the pattern generator 1301 for low power operation, while the sequence generator 1302 - which is the fastest part of the AQFP circuit 1401 and must operate at the "full" rate - may utilise the principle explained above, i.e. having the plasma frequencies of the Josephson junctions therein as integer multiples of the clocking signal frequency on line 1305.

The technology described above may allow pushing the driving-related dissipation so low that even very large quantum computing systems with thousands, tens of thousands, or even millions of qubits. As a rough estimate, an average of 10 000 switching elements may be needed to control a single qubit, including readout, feedback, reset, and the like. Autonomic error correction may prove to be more power efficient than feedback-based, but feedback is assumed to be present for the moment. A rate of 25 GHz may be assumed for flipping bits on the average, and while some computation may be reversible by nature, which would allow average dissipation less than the Landauer limit, it is safe to assume a dissipation of at least the Landauer limit E = k_{B}T ln2 amount of energy per bit flip per gate on the average.

According to a further assumption, the DC biases can be produced with persistent current switches which dissipate zero power in the steady state, so this part of the arrangement does not pose any dissipation-related problems in scaling up the size. Yet another assumption is operating a QPU that utilizes all-rf perfect off two qubits gates, which then allows utilizing static couplers. Consequently, there is no separate driving for couplers needed, so the discussion may be limited to just single qubits and two-qubit gates are done with particular pulse-sequences driven simultaneously to two individual qubits. This scheme may also facilitate static qubits, which may allow a much higher degree of immunity to flux noise.

The number of 10 000 switching elements is based on a comparison to early microprocessors like the 6502, which had 3218 transistors, and assuming some excess for memory and the like. It should be noted, though, that the dissipation estimate may be even somewhat pessimistic: memory can for the most part function reversibly and need not dissipate energy except when erasing bits. Additionally, some of the dissipation related to erasing could possibly be carried out of the cryostat, if it proves to be possible to dump the excess energy during erasure via a cable to room temperature, for example via interaction with the AQFP clock.

The cryostat may have a cooling power of, say, 300 microwatts when operating at 30 mK, which should be cold enough for maintaining low enough a thermal population. Calculating with these values, one could build a quantum computing system with about 4 000 000 qubits before running into dissipation-related technical limits. According to the assumptions, one would do most of the processing within the cryostat with AQFP right next to the QPU, so only a relatively small number of cables would go in and out of the cryostat. These cables could be used mainly for programming the AQFP logic with predetermined programs and, at the end of the computation, for reading out the statistics. No real time driving signals (or very few of them) would be carried by said cables, which means that the related heating issues would also remain at an acceptable level.

Figs. 16 and 17 show how the same principle can be utilized also in very power efficient classical computing. The three blocks shown as 1601, 1602, and 1603 in fig. 16 each have an internal structure like that explained above with reference to fig. 5. Together, they constitute an AQFP majority gate. Using this kind of building blocks, it is possible to build other gates such as two-input NAND or AND gates. A more schematical corresponding illustration is shown in fig. 17.

Realizing the frequency relation in which the plasma frequency of a Josephson junction is an integral multiple of the clocking signal frequency may necessitate carefully manufacturing the Josephson junction and its associated circuit elements, so that the plasma frequency achieves the desired value. One possible way is to manufacture the Josephson junction in a conventional manner and then to utilise laser annealing or some other known later fine-tuning method to set the plasma frequency right.

It is obvious to a person skilled in the art that with the advancement of technology, the basic idea of the invention may be implemented in various ways. The invention and its embodiments are thus not limited to the examples described above, instead they may vary within the scope of the claims.

## Claims

1. An Adiabatic Quantum-Flux-Parametron circuit, in the following an AQFP circuit, comprising:
- a Josephson junction (501) or an array of Josephson junctions (501, 502), said Josephson junction (501) or each Josephson junction (501, 502) in said array having a respective plasma frequency,
- a clocking signal line (503),
- an inductive coupler (504) between said clocking signal line (503) and said Josephson junction (501), or an array of inductive couplers (504, 505) between said clocking signal line (503) and each Josephson junction (501, 502) in said array respectively, and
- a data signal line (506) between a data signal source and said Josephson junction (501) or each Josephson junction (501, 502) in said array;
wherein said AQFP circuit is configured to feed into said clocking signal line (503) an oscillating clocking signal (701) having a clocking signal frequency,
**characterized in that** said clocking signal frequency is selected so that said plasma frequency or each respective plasma frequency is an integral multiple of said clocking signal frequency.

2. An AQFP circuit according to claim 1, configured to feed into said clocking signal line (503), as said oscillating clocking signal, a compressed sinusoidal waveform that contains a base frequency (801) and a predetermined set of harmonics (802, 803, 804, 805) of said base frequency (801).

3. An AQFP circuit according to claim 1 or 2, configured to feed into said clocking signal line (503), as said oscillating clocking signal (701), an oscillating signal a base frequency of which is higher than 5 GHz, preferably higher than 10 GHz, and most preferably higher than 12 GHz.

4. An AQFP circuit according to any of the preceding claims, configured to feed into said data signal line (506) a data pattern of varying polarities, for making an output current of said AQFP circuit exhibit a pulsed form (702) in which consecutive current pulses have polarities following said varying polarities of the data pattern.

5. An AQFP circuit according to claim 4, wherein:
- said clocking signal line (503), said Josephson junction (501) or array of Josephson junctions (501, 502), said inductive coupler (504) or array of inductive couplers (504, 505), and said data signal line (506) belong to a sequence generator (1302) that has an output, said data signal line (506) being an input of said sequence generator (1302), and
- the AQFP circuit comprises a control pulse generator (1303) coupled to said output of said sequence generator (1302), configured to use the pulsed form of the output current of said sequence generator (1302) to produce a corresponding sequence of control voltage pulses.

6. An AQFP circuit according to claim 5, wherein:
- said control pulse generator (1303) comprises:
-- a further Josephson junction (301) or a further array of Josephson junctions (301, 302),
-- a further clocking signal line (1306),
-- a further inductive coupler (307, 309) between said further clocking signal line (1306) and said further Josephson junction (301) or a further array of inductive couplers (307, 309; 308, 310) between said further clocking signal line (1306) and each Josephson junction (301, 302) in said further array respectively, and
**--** a further data signal line between said output of said sequence generator (1302) and said further Josephson junction (301) or each Josephson junction (301, 302) in said further array;
- the AQFP circuit is configured to feed into said further clocking signal line (1306) a further oscillating clocking signal, a base frequency of which is lower than the base frequency of the oscillating clocking signal fed into the clocking signal line (503, 1305) of the sequence generator (1302).

7. A method for operating an Adiabatic Quantum-Flux-Parametron circuit, in the following an AQFP circuit, which AQFP circuit comprises:
- a Josephson junction (501) or an array of Josephson junctions (501, 502), said Josephson junction (501) or each Josephson junction (501, 502) in said array having a respective plasma frequency,
- a clocking signal line (503),
- an inductive coupler (504) between said clocking signal line (503) and said Josephson junction (501), or an array of inductive couplers (504, 505) between said clocking signal line (503) and each Josephson junction (501, 502) in said array respectively, and
- a data signal line (506) between a data signal source and said Josephson junction (501) or each Josephson junction (501, 502) in said array;
wherein said method comprises feeding into said clocking signal line (503) an oscillating clocking signal (701) having a clocking signal frequency,
**characterised in that** the method comprises selecting said clocking signal frequency so that said plasma frequency or each respective plasma frequency is an integral multiple of said clocking signal frequency.

8. A method according to claim 7, comprising feeding into said clocking signal line (503), as said oscillating clocking signal, a compressed sinusoidal waveform that contains a base frequency (801) and a predetermined set of harmonics (802, 803, 804, 805) of said base frequency (801).

9. A method according to claim 7 or 8, comprising feeding into said clocking signal line (503), as said oscillating clocking signal (701), an oscillating signal a base frequency of which is higher than 5 GHz, preferably higher than 10 GHz, and most preferably higher than 12 GHz.

10. A method according to any of claims 7 to 9, comprising feeding into said data signal line (506) a data pattern of varying polarities, for making an output current of said AQFP circuit exhibit a pulsed form (702) in which consecutive current pulses have polarities following said varying polarities of the data pattern.

11. A quantum computing system comprising at least one AQFP circuit according to any of claims 1 to 6.

12. A quantum computing method comprising, as a part of the method, operating an AQFP circuit in accordance with any of claims 7 to 10.

## Patentansprüche

1. Adiabatische Quanten-Fluss-Parametron-Schaltung, im Folgenden AQFP-Schaltung, umfassend:
- einen Josephson-Kontakt (501) oder ein Array von Josephson-Kontakten (501, 502), wobei der Josephson-Kontakt (501) oder jeder Josephson-Kontakt (501, 502) in dem Array eine jeweilige Plasmafrequenz aufweist,
- eine Taktsignalleitung (503),
- einen induktiven Koppler (504) zwischen der Taktsignalleitung (503) und dem Josephson-Kontakt (501) oder ein Array von induktiven Kopplern (504, 505) zwischen der Taktsignalleitung (503) und jeweils jedem Josephson-Kontakt (501, 502) in dem Array, und
- eine Datensignalleitung (506) zwischen einer Datensignalquelle und dem Josephson-Kontakt (501) oder jedem Josephson-Kontakt (501, 502) in dem Array;
wobei die AQFP-Schaltung dazu konfiguriert ist, ein oszillierendes Taktsignal (701) mit einer Taktsignalfrequenz in die Taktsignalleitung (503) einzuspeisen,
**dadurch gekennzeichnet, dass** die Taktsignalfrequenz so gewählt ist, dass die Plasmafrequenz oder jede jeweilige Plasmafrequenz ein ganzzahliges Vielfaches der Taktsignalfrequenz ist.

2. AQFP-Schaltung nach Anspruch 1, die dazu konfiguriert ist, als das oszillierende Taktsignal eine komprimierte sinusförmige Wellenform, die eine Grundfrequenz (801) und einen vorbestimmten Satz von Harmonischen (802, 803, 804, 805) der Grundfrequenz (801) enthält, in die Taktsignalleitung (503) einzuspeisen.

3. AQFP-Schaltung nach Anspruch 1 oder 2, die dazu konfiguriert ist, als das oszillierende Taktsignal (701) ein oszillierendes Signal in die Taktsignalleitung (503) einzuspeisen, dessen Grundfrequenz höher als 5 GHz, vorzugsweise höher als 10 GHz und am meisten bevorzugt höher als 12 GHz ist.

4. AQFP-Schaltung nach einem der vorhergehenden Ansprüche, die dazu konfiguriert ist, ein Datenmuster mit variierenden Polaritäten in die Datensignalleitung (506) einzuspeisen, um zu bewirken, dass ein Ausgangsstrom der AQFP-Schaltung eine gepulste Form (702) zeigt, bei der aufeinanderfolgende Strompulse Polaritäten aufweisen, die den variierenden Polaritäten des Datenmusters folgen.

5. AQFP-Schaltung nach Anspruch 4, wobei:
- die Taktsignalleitung (503), der Josephson-Kontakt (501) oder das Array von Josephson-Kontakten (501, 502), der induktive Koppler (504) oder das Array von induktiven Kopplern (504, 505) und die Datensignalleitung (506) zu einem Sequenzgenerator (1302) gehören, der einen Ausgang aufweist, wobei die Datensignalleitung (506) ein Eingang des Sequenzgenerators (1302) ist, und
- die AQFP-Schaltung einen Steuerpulsgenerator (1303) umfasst, der mit dem Ausgang des Sequenzgenerators (1302) gekoppelt ist, der dazu konfiguriert ist, die gepulste Form des Ausgangsstroms des Sequenzgenerators (1302) zu verwenden, um eine entsprechende Sequenz von Steuerspannungspulsen zu erzeugen.

6. AQFP-Schaltung nach Anspruch 5, wobei:
- der Steuerpulsgenerator (1303) umfasst:
-- einen weiteren Josephson-Kontakt (301) oder ein weiteres Array von Josephson-Kontakten (301, 302),
-- eine weitere Taktsignalleitung (1306),
-- einen weiteren induktiven Koppler (307, 309) zwischen der weiteren Taktsignalleitung (1306) und dem weiteren Josephson-Kontakt (301) oder ein weiteres Array von induktiven Kopplern (307, 309; 308, 310) zwischen der weiteren Taktsignalleitung (1306) und jeweils jedem Josephson-Kontakt (301, 302) in dem weiteren Array, und
-- eine weitere Datensignalleitung zwischen dem Ausgang des Sequenzgenerators (1302) und dem weiteren Josephson-Kontakt (301) oder jedem Josephson-Kontakt (301, 302) in dem weiteren Array;
- die AQFP-Schaltung dazu konfiguriert ist, ein weiteres oszillierendes Taktsignal in die weitere Taktsignalleitung (1306) einzuspeisen, dessen Grundfrequenz niedriger ist als die Grundfrequenz des oszillierenden Taktsignals, das in die Taktsignalleitung (503, 1305) des Sequenzgenerators (1302) eingespeist wird.

7. Verfahren zum Betreiben einer adiabatischen Quanten-Fluss-Parametron-Schaltung, im Folgenden AQFP-Schaltung, wobei die AQFP-Schaltung umfasst:
- einen Josephson-Kontakt (501) oder ein Array von Josephson-Kontakten (501, 502), wobei der Josephson-Kontakt (501) oder jeder Josephson-Kontakt (501, 502) in dem Array eine jeweilige Plasmafrequenz aufweist,
- eine Taktsignalleitung (503),
- einen induktiven Koppler (504) zwischen der Taktsignalleitung (503) und dem Josephson-Kontakt (501) oder ein Array von induktiven Kopplern (504, 505) zwischen der Taktsignalleitung (503) und jeweils jedem Josephson-Kontakt (501, 502) in dem Array, und
- eine Datensignalleitung (506) zwischen einer Datensignalquelle und dem Josephson-Kontakt (501) oder jedem Josephson-Kontakt (501, 502) in dem Array;
wobei das Verfahren das Einspeisen eines oszillierenden Taktsignals (701) mit einer Taktsignalfrequenz in die Taktsignalleitung (503) umfasst,
**dadurch gekennzeichnet, dass** das Verfahren das Auswählen der Taktsignalfrequenz so umfasst, dass die Plasmafrequenz oder jede jeweilige Plasmafrequenz ein ganzzahliges Vielfaches der Taktsignalfrequenz ist.

8. Verfahren nach Anspruch 7, umfassend das Einspeisen, als das oszillierende Taktsignal, einer komprimierten sinusförmigen Wellenform, die eine Grundfrequenz (801) und einen vorbestimmten Satz von Harmonischen (802, 803, 804, 805) der Grundfrequenz (801) enthält, in die Taktsignalleitung (503).

9. Verfahren nach Anspruch 7 oder 8, umfassend das Einspeisen, als das oszillierende Taktsignal (701), eines oszillierenden Signals, dessen Grundfrequenz höher als 5 GHz, vorzugsweise höher als 10 GHz und am meisten bevorzugt höher als 12 GHz ist, in die Taktsignalleitung (503).

10. Verfahren nach einem der Ansprüche 7 bis 9, umfassend das Einspeisen eines Datenmusters mit variierenden Polaritäten in die Datensignalleitung (506), um zu bewirken, dass ein Ausgangsstrom der AQFP-Schaltung eine gepulste Form (702) zeigt, bei der aufeinanderfolgende Strompulse Polaritäten aufweisen, die den variierenden Polaritäten des Datenmusters folgen.

11. Quantencomputersystem, umfassend mindestens eine AQFP-Schaltung nach einem der Ansprüche 1 bis 6.

12. Quantencomputerverfahren, umfassend: Betreiben, als einen Teil des Verfahrens, einer AQFP-Schaltung nach einem der Ansprüche 7 bis 10.

## Revendications

1. Circuit de paramétron à flux quantique adiabatique, ci-après dénommé circuit AQFP, comprenant :
- une jonction Josephson (501) ou un réseau de jonctions Josephson (501, 502), ladite jonction Josephson (501) ou chaque jonction Josephson (501, 502) dans ledit réseau présentant une fréquence de plasma respective,
- une ligne (503) de signal d'horloge,
- un coupleur inductif (504) entre ladite ligne (503) de signal d'horloge et ladite jonction Josephson (501), ou un réseau de coupleurs inductifs (504, 505) entre ladite ligne (503) de signal d'horloge et chaque jonction Josephson (501, 502) dans ledit réseau respectivement, et
- une ligne (506) de signal de données entre une source de signal de données et ladite jonction Josephson (501) ou chaque jonction Josephson (501, 502) dans ledit réseau ; dans lequel ledit circuit AQFP est configuré pour envoyer à ladite ligne (503) de signal d'horloge un signal d'horloge oscillant (701) présentant une fréquence de signal d'horloge, **caractérisé en ce que** ladite fréquence de signal d'horloge est sélectionnée de sorte que ladite fréquence de plasma ou chaque fréquence de plasma respective soit un multiple entier de ladite fréquence de signal d'horloge.

2. Circuit AQFP selon la revendication 1, configuré pour envoyer à ladite ligne (503) de signal d'horloge, en tant que ledit signal d'horloge oscillant, une forme d'onde sinusoïdale comprimée qui contient une fréquence de base (801) et un ensemble prédéterminé d'harmoniques (802, 803, 804, 805) de ladite fréquence de base (801).

3. Circuit AQFP selon la revendication 1 ou la revendication 2, configuré pour envoyer à ladite ligne (503) de signal d'horloge, en tant que ledit signal d'horloge oscillant (701), un signal oscillant dont une fréquence de base est supérieure à 5 GHz, préférablement supérieure à 10 GHz, et le plus préférentiellement supérieure à 12 GHz.

4. Circuit AQFP selon l'une quelconque des revendications précédentes, configuré pour envoyer à ladite ligne (506) de signal de données un motif de données de polarités variables, pour faire en sorte qu'un courant de sortie dudit circuit AQFP présente une forme pulsée (702) dans laquelle des impulsions de courant consécutives présentent des polarités suivant lesdites polarités variables du motif de données.

5. Circuit AQFP selon la revendication 4, dans lequel :
- ladite ligne (503) de signal d'horloge, ladite jonction Josephson (501) ou ledit réseau de jonctions Josephson (501, 502), ledit coupleur inductif (504) ou ledit réseau de coupleurs inductifs (504, 505), et ladite ligne (506) de signal de données appartiennent à un générateur (1302) de séquences qui présente une sortie, ladite ligne (506) de signal de données étant une entrée dudit générateur (1302) de séquences, et
- le circuit AQFP comprend un générateur (1303) d'impulsions de commande couplé à ladite sortie dudit générateur (1302) de séquences, configuré pour utiliser la forme pulsée du courant de sortie dudit générateur (1302) de séquences pour produire une séquence correspondante d'impulsions de tension de commande.

6. Circuit AQFP selon la revendication 5, dans lequel :
- ledit générateur (1303) d'impulsions de commande comprend :
-- une autre jonction Josephson (301) ou un autre réseau de jonctions Josephson (301, 302),
-- une autre ligne (1306) de signal d'horloge,
-- un autre coupleur inductif (307, 309) entre ladite autre ligne (1306) de signal d'horloge et ladite autre jonction Josephson (301) ou un autre réseau de coupleurs inductifs (307, 309 ; 308, 310) entre ladite autre ligne (1306) de signal d'horloge et chaque jonction Josephson (301, 302) dans ledit autre réseau respectivement, et
-- une autre ligne de signal de données entre ladite sortie dudit générateur (1302) de séquences et ladite autre jonction Josephson (301) ou chaque jonction Josephson (301, 302) dans ledit autre réseau ;
- le circuit AQFP est configuré pour envoyer à ladite autre ligne (1306) de signal d'horloge un autre signal d'horloge oscillant, dont une fréquence de base est inférieure à la fréquence de base du signal d'horloge oscillant envoyé à la ligne (503, 1305) de signal d'horloge du générateur (1302) de séquences.

7. Procédé de fonctionnement d'un circuit de paramétron à flux quantique adiabatique, ci-après dénommé circuit AQFP, lequel circuit AQFP comprend :
- une jonction Josephson (501) ou un réseau de jonctions Josephson (501, 502), ladite jonction Josephson (501) ou chaque jonction Josephson (501, 502) dans ledit réseau présentant une fréquence de plasma respective,
- une ligne (503) de signal d'horloge,
- un coupleur inductif (504) entre ladite ligne (503) de signal d'horloge et ladite jonction Josephson (501), ou un réseau de coupleurs inductifs (504, 505) entre ladite ligne (503) de signal d'horloge et chaque jonction Josephson (501, 502) dans ledit réseau respectivement, et
- une ligne (506) de signal de données entre une source de signal de données et ladite jonction Josephson (501) ou chaque jonction Josephson (501, 502) dans ledit réseau ;
dans lequel ledit procédé comprend l'envoi à ladite ligne (503) de signal d'horloge d'un signal d'horloge oscillant (701) présentant une fréquence de signal d'horloge,
**caractérisé en ce que** le procédé comprend la sélection de ladite fréquence de signal d'horloge de sorte que ladite fréquence de plasma ou chaque fréquence de plasma respective soit un multiple entier de ladite fréquence de signal d'horloge.

8. Procédé selon la revendication 7, comprenant l'envoi à ladite ligne (503) de signal d'horloge, en tant que ledit signal d'horloge oscillant, d'une forme d'onde sinusoïdale comprimée qui contient une fréquence de base (801) et un ensemble prédéterminé d'harmoniques (802, 803, 804, 805) de ladite fréquence de base (801).

9. Procédé selon la revendication 7 ou la revendication 8, comprenant l'envoi à ladite ligne (503) de signal d'horloge, en tant que ledit signal d'horloge oscillant (701), d'un signal oscillant dont une fréquence de base est supérieure à 5 GHz, préférablement supérieure à 10 GHz, et le plus préférentiellement supérieure à 12 GHz.

10. Procédé selon l'une quelconque des revendications 7 à 9, comprenant l'envoi à ladite ligne (506) de signal de données d'un motif de données de polarités variables, pour faire en sorte qu'un courant de sortie dudit circuit AQFP présente une forme pulsée (702) dans laquelle des impulsions de courant consécutives présentent des polarités suivant lesdites polarités variables du motif de données.

11. Système d'informatique quantique comprenant au moins un circuit AQFP selon l'une quelconque des revendications 1 à 6.

12. Procédé d'informatique quantique comprenant, dans le cadre du procédé, le fonctionnement d'un circuit AQFP conformément à l'une quelconque des revendications 7 à 10.
